Europäisches Patentamt

European Patent Office

Office européen des brevets

(11) Publication number: **0 251 734 B1**

# EUROPEAN PATENT SPECIFICATION

(45) Date of publication of patent specification: **09.09.92**  (51) Int. Cl.5: **G11C  7/00**, G11C 11/419

(21) Application number: **87305719.4**

(22) Date of filing: **26.06.87**

(54) Static random-access memory devices.

<table>
<tr><td>

(30) Priority: **30.06.86 JP 153311/86**

(43) Date of publication of application:
**07.01.88 Bulletin  88/01**

(45) Publication of the grant of the patent:
**09.09.92 Bulletin  92/37**

(84) Designated Contracting States:
**DE FR GB NL**

(56) References cited:
**EP-A- 0 139 385**

**THIRD CALTECH CONFERENCE ON VERY
LARGE SCALE INTEGRATION, 21st-23rd
March 1983, Pasadena, CA., edited by Randal
Bryant, pages 275-285, Rockville, MD., US;
E.H.FRANK et al.: "A self-timed static RAM"**

</td><td>

(73) Proprietor: **SONY CORPORATION
7-35 Kitashinagawa 6-chome Shinagawa-ku
Tokyo 141(JP)**

(72) Inventor: **Taniguchi, Hitoshi
Pat. Div. Sony Corporation 7-35
Kitashinagawa
Shinagawa-ku Tokyo 141(JP)**
Inventor: **Ishio, Keisuke
Pat. Div. Sony Corporation 7-35
Kitashinagawa
Shinagawa-ku Tokyo 141(JP)**

(74) Representative: **Pilch, Adam John Michael et
al
D. YOUNG & CO. 10 Staple Inn
London WC1V 7RD(GB)**

</td></tr>
</table>

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

This invention relates to static random-access memory devices.

It is known for random-access memory (RAM) devices to be organised using a plurality of integrated circuit chips in order to increase memory capacity. In such RAMs, address data designates a selected memory cell, and chip selection for designating a selected chip is also performed. For example, a 128-kbit memory static RAM may comprise two chips each having 64-kbit memory cells. In this case, a 17-bit signal is used as an address signal supplied to the address input terminals. The most significant bit is used as a chip selection signal which is supplied to the respective chip by means of a decoder, so as to designate which one of the chips is to be used. The remaining 16 bits are supplied to the designated chip to be used as an address signal to designate the memory cell to be accessed. The data stored in the chip which is selected by the chip selecting signal, at the memory cell which is selected by the 16-bit address signal, is then cutput to an output terminal.

A high-speed static RAM (SRAM) comprising a single chip, which includes memory cells each comprising a flip-flop circuit composed of, for example, metal-oxide semiconductor field-effect transistors (MOSFETs), has previously been proposed. In this high-speed SRAM, the number of memory cells (for example 64) is actually equal to the memory capacity, and the memory cells are arranged in the form of a lattice. One of the memory cells is selected by address input signals comprising X (line) and Y (column) signals.

According to this previously-proposed static RAM, when selecting an address, address signals are detected to produce equalising signals. In response to the equalising signals, the electrical potentials of the bit lines assume an intermediate potential between a high-level electrical potential and a low-level electrical potential. Therefore, both of the respective column-selecting transistors are ON. In this case, the electrical potentials of both data lines are at an intermediate potential between the high-level and low-level potentials. At this time, data signals are output from the memory cell which is selected by the column-selecting signals and the line-selecting signals produced from Y and X decoders, respectively, and are rapidly transferred to the data lines from the bit lines. These data signals are supplied to the data output terminal by means of a common data line.

However, when selection of one of a plurality of such chips is necessary, both of the bit lines are at a high-level, so that both of the column-selecting transistors are OFF at the time that the chip is accessed. Therefore, operation is impeded until the electrical potentials of the bit lines are decreased to a given level, and thus transferring of the data signals from the bit lines to the data lines is delayed. Accordingly, there is a disadvantage in that the transfer rate of data signals is decreased when selection between the chips is necessary, as compared with the situation when only selection of an address for a single chip is necessary. This makes the design of a high-speed static RAM difficult.

According to the present invention there is provided a static random-access memory device comprising:

a plurality of memory cells arranged in rows and columns, for storing data;

pairs of column-selecting transistors for selecting a respective column of said memory cells;

pairs of complementary bit lines to which said plurality of memory cells and said pairs of column-selecting transistors are connected;

pairs of static loads each coupled between a respective one of said pairs of complementary bit lines and a power supply terminal; and

a row decoder responsive to a chip-selecting signal for selecting one of said rows of said memory cells;

characterised by a voltage control circuit connected to said pairs of bit lines for adjusting the electrical potential of said bit lines for a predetermined period in response to said chip-selecting signal so as to allow one of said pairs of column-selecting transistors to turn on during chip selection for writing or reading.

A preferred embodiment of the invention, to be described in greater detail hereinafter, overcomes or at least reduces the aforementioned disadvantage and provides a SRAM device which can operate at high speed, not only when address selecting operations but also when chip selecting operations are required.

In order to accomplish this, the voltage control circuit adjusts the electrical potential of the bit lines to allow a column-selecting transistor to operate while selection of one of the chips is being performed.

The voltage control circuit may be a pull-down circuit. Preferably, the voltage control circuit comprises n-channel MOSFETs, the drains of which are connected to the bit lines, with the sources being connected to earth (ground) and the gates being connected to each other. In addition, the preferred static random-access memory device further comprises a bit-line equalising circuit and a data-line load circuit.

The invention will now be described by way of example with reference to the accompanying drawings, in which:

Figure 1 is a block diagram of a static RAM having two chips, according to an embodiment of the invention;

Figure 2 is a block diagram of a static RAM according to a preferred embodiment of the invention;

Figure 3 is a block diagram of a pull-down signal producing circuit according to the preferred embodiment of the invention; and

Figure 4 is a timing chart for understanding the operation of the static RAM shown in Figure 2.

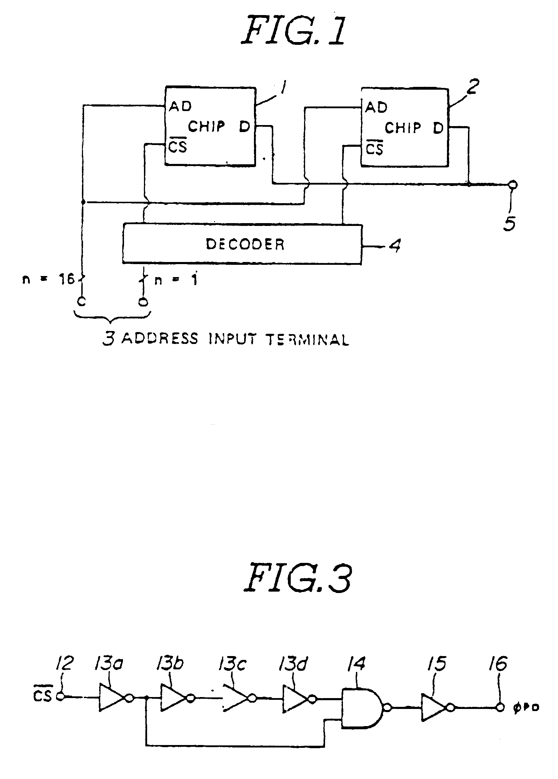

Referring to Figure 1 of the drawings, a static random-access memory (RAM), according to an embodiment of the present invention, comprises two chips 1 and 2. For example, each of the chips 1 and 2 may have 64-kbit memories so that the combined static RAM therefore totals 128 kbits of memory capacity. In this case, a 17-bit signal is used as an address signal to be supplied to address input terminals 3. The most significant bit thereof is used as a chip selection signal $\overline{CS}$ which is supplied to a selected one of the chips 1 and 2 by means of a decoder 4, so as to select which one of the chips is to be used. The remaining 16 bits are used as an address signal AD for memory cell selection to be supplied to the chips 1 and 2. Therefore, a data signal stored in the one of the chips which is selected by the chip selection signal, at the memory cell which is selected by the 16-bit address signal AD, is output to an output terminal 5.

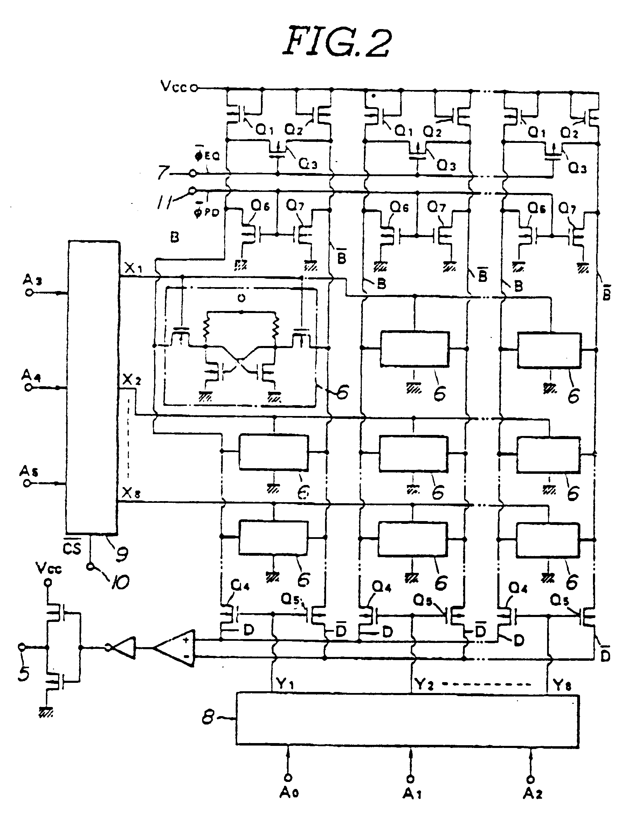

In the preferred embodiment, as shown in Figure 2, each of the chips 1 and 2 includes a plurality of (for example 64) memory cells 6, the number of which is chosen to be equal to the number of bits of memory capacity. The memory cells 6 each comprise a flip-flop circuit including a metal-oxide semiconductor field-effect transistor (MOSFET), arranged in the form of a lattice. One of the memory cells 6 is selected by an address input signal comprising X (line) and Y (column) components.

In order to simplify the description of the static RAM, the construction of a column of the static RAM and its operation will now be described.

In Figure 2, a power supply terminal $V_{CC}$ to which, for example, direct current at 5V is supplied, is connected to one end of each of bit lines B and $\overline{B}$ by means of respective n-channel MOSFETs $Q_1$ and $Q_2$ constituting respective loads. The other ends of the bit lines B and $\overline{B}$ are each connected to a corresponding end of respective data lines D and $\overline{D}$ by means of n-channel MQSFETs $Q_4$ and $Q_5$ constituting column-selecting transistors. The other ends of the data lines D and $\overline{D}$ are connected to the data signal output terminal 5 by means of a common data line, output circuitry and the like. In this case, a given number of memory cells 6, for example eight memory cells, are connected between the bit lines B and $\overline{B}$. The electric potentials of the bit lines $\overline{B}$ are inverted relative to those of the corresponding bit lines B. That is, one is at a high level "Hi" when the other is at a low level "Lo". The sources and drains of p-channel MOS-FETs $Q_3$ constituting bit line equalising transistors are connected between the bit lines B and $\overline{B}$. Equalising signals $\overline{\phi}_{EQ}$ are supplied from an equalising signal input terminal 7 to the gates of the MOSFETs $Q_3$. When the equalising signals $\overline{\phi}_{EQ}$ are thus supplied, current flows through the MOS-FETs $Q_3$. In addition, address signals are supplied to a Y decoder 8 by means of half of the address-signal input terminals $A_0$, $A_1$ and $A_2$ and to a X decoder 9 by means of the other half of the address-signal input terminals $A_3$, $A_4$ and $A_5$. In this case, when the address signal is composed of 16 bits, 8 bits each of the address signal are supplied to the Y decoder 8 and to the X decoder 9.In addition, the Y decoder 8 supplies column selecting signals $Y_1$, $Y_2$, --- $Y_8$ to the junction between both gates of the MOSFETs $Q_4$ and $Q_5$ which constitute column selecting transistors. The X decoder 9 supplies row selecting signals $X_1$, $X_2$, --- $X_8$ to respective memory cells 6. When one of the chips is selected, a chip selecting signal $\overline{CS}$ input at a chip selecting input terminal 10 is supplied to the X decoder 9.

A high-level electrical potential $V_{BH}$ of the bit lines B and $\overline{B}$ when the static RAM is being read out, can be expressed by the following formula:

$$V_{BH} = V_{CC} - (V_{TH} + \Delta V_{TH})$$

in which $V_{CC}$ is the power supply voltage, $V_{TH}$ is the threshold voltage of the MOSFETs $Q_1$ and $Q_2$, and $\Delta V_{TH}$ is the increase of the threshold voltage by virtue of the body effect (the substrate effect). For example, when $V_{CC}$ is 5V, $V_{TH}$ is 0.7V and $\Delta V_{TH}$ is 0.9V, $V_{BH}$ is 3.4V. In this case, the electrical potential $V_{BL}$ of the low level "Lo" bit line is, for example, 3.0V. On the other hand, the electrical potentials of the data lines D and $\overline{D}$ are higher than the electrical potentials of the bit lines B and $\overline{B}$ so that high-speed operation can be performed. For example, it may be established that the high level "Hi" electrical potential is 4V and the low level "Lo" electrical potential is 3.7V. Therefore, the high level "Hi" column selecting transistors $Q_4$ and $Q_5$ are OFF.

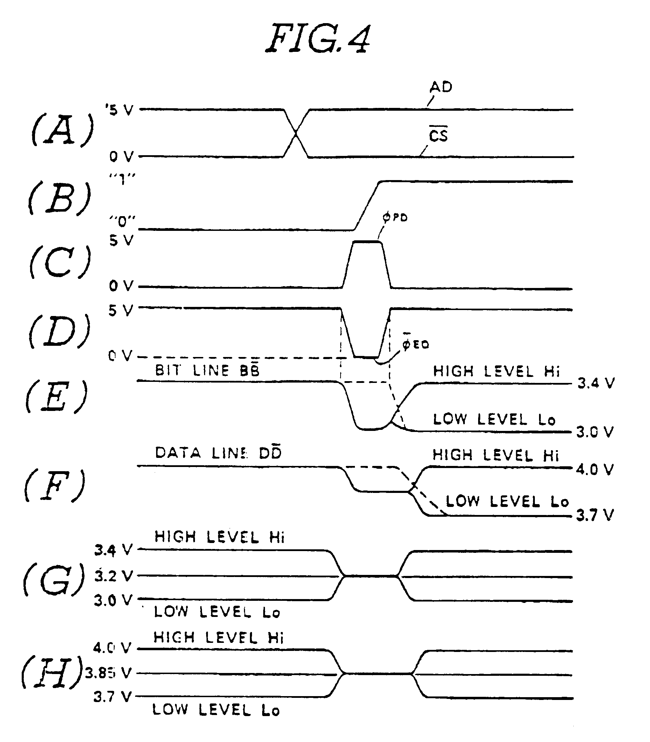

In this preferred embodiment, the bit lines B and $\overline{B}$ are connected to the drains of n-channel MOSFETs $Q_6$ and $Q_7$ constituting voltage control circuits or pull-down circuits. The sources of the MOSFETs $Q_6$ and $Q_7$ are connected to earth. In addition, the gates of the MOSFETs $Q_6$ and $Q_7$ are connected to each other. The junction of the gates is connected to a pull-down signal input terminal 11, to which pull-down signals $\phi_{PD}$ are supplied when one of the chips is selected. In this case, the

pull-down signals $\phi_{PD}$ are produced by a pull-down signal producing circuit, shown in Figure 3, which includes a chip selecting signal input terminal 12 to which the chip selecting signals $\overline{CS}$ are supplied. The chip selecting signal input terminal 12 is connected to one input terminal of a NAND circuit 14 by means of four inverter circuits 13a, 13b, 13c and 13d connected in series. The other input terminal of the NAND circuit 14 is connected to the output of the inverter circuit 13a. The output of the NAND circuit 14 is connected to a pull-down signal output terminal 16 by means of a further inverter circuit 15. In this case, the inverter circuits 13b, 13c and 13d constitute a time-delay circuit. For example, when the chip selecting signal $\overline{CS}$ shown in Figure 4A is supplied to the chip selecting signal input terminal 12, the pull-down signal output terminal 16 produces a pull-down signal $\phi_{PD}$ as shown in Figure 4C.

When selecting an address of the static RAM shown in Figure 2, address signals AD shown in Figure 4A, and the low level chip selecting signal $\overline{CS}$ are detected to produce equalising signals $\overline{\phi}_{EQ}$ shown in Figure 4D. In response to the equalising signals $\overline{\phi}_{EQ}$, the electrical potentials of the bit lines B and $\overline{B}$ become, as shown in Figure 4G, the intermediate potential between the high level "Hi" electrical potential and the low level "Lo" electrical potential, which is for example 3.2V when the high level "Hi" and the low level "Lo" electrical potentials are 3.4V and 3.0V, respectively. Therefore, both of the column selecting transistors $Q_4$ and $Q_5$ are ON. In this case, the electrical potential of each of the data lines D and $\overline{D}$ is, as shown in Figure 4H, the intermediate potential between the high level "Hi" and the low level "Lo" electrical potentials, which is for example 3.85V when the high level "Hi" and the low level "Lo" electrical potentials are 4V and 3.7V, respectively. At this time, the data signal is output from the memory cell which is selected by the column-selecting signal and the line-selecting signal shown in Figure 4B, which signals are produced from the Y and X decoders 8 and 9, respectively, and the data signals are rapidly transferred to the data lines D and $\overline{D}$ from the bit lines B and $\overline{B}$. These data signals are supplied to the data output terminal 5 by means of the common data line and other circuitry.

In addition, when selecting a chip, the pull-down signals $\phi_{PD}$ shown in Figure 4C and the bit line equalising signals $\overline{\phi}_{EQ}$ shown in Figure 4D are produced by the chip selecting signals $\overline{CS}$, and the pull-down signals $\phi_{PD}$ are supplied to the pull down signal input terminal 11. Therefore, the MOSFETs $Q_6$ and $Q_7$ which constitute the pull-down circuit and are connected to the bit lines B and $\overline{B}$, are ON when the pull-down signals $\phi_{PD}$ are supplied thereto. As a result, as shown in Figure 4E, the electrical potentials of the bit lines B and $\overline{B}$ are decreased below, for example, 3.2V which is the electrical potential at which the column-selecting transistors $Q_4$ and $Q_5$ turn ON. At this time, the electrical potentials of the data lines D and $\overline{D}$ become the intermediate potential as shown in Figure 4F, for example 3.85V, between the high level "Hi" and the low level "Lo". At this time, since the equalising signals $\overline{\phi}_{EQ}$ have the operating potential shown in Figure 4D, the aforementioned operation is performed to allow the transistors $Q_4$ and $Q_5$ of the chips 1 and 2 to have electrical potentials by which the transistors $Q_4$ and $Q_5$ are operated. At this time, data signals are output to the bit lines B and $\overline{B}$ from that memory cell which is selected by the column-selecting signals and the line-selecting signals produced from the Y and X decoders 8 and 9, respectively, and rapidly transferred to the data lines D and $\overline{D}$. As a result, when the chip selecting operation is also performed, data signals can be transferred at the same speed as in the case where only an address is selected. As a result, large capacity high-speed static RAMs having a plurality of chips can readily be manufactured.

**Claims**

1. A static random-access memory device comprising:

   a plurality of memory cells (6) arranged in rows and columns, for storing data;

   pairs of column-selecting transistors ($Q_4$,$Q_5$) for selecting a respective column of said memory cells (6);

   pairs of complementary bit lines (B,$\overline{B}$) to which said plurality of memory cells (6) and said pairs of column-selecting transistors ($Q_4$,$Q_5$) are connected;

   pairs of static loads ($Q_1$,$Q_2$) each coupled between a respective one of said pairs of complementary bit lines (B,$\overline{B}$) and a power supply terminal ($V_{CC}$); and

   a row decoder (9) responsive to a chip-selecting signal ($\overline{CS}$) for selecting one of said rows of said memory cells (6);

   characterised by a voltage control circuit ($Q_6$,$Q_7$) connected to said pairs of bit lines (B,$\overline{B}$) for adjusting the electrical potential of said bit lines (B,$\overline{B}$) for a predetermined period in response to said chip-selecting signal ($\overline{CS}$) so as to allow one of said pairs of column-selecting transistors ($Q_4$,$Q_5$) to turn on during chip selection for writing or reading.

2. A memory device according to claim 1, wherein said voltage control circuit is a pull-down circuit ($Q_6$,$Q_7$).

3. A memory device according to claim 2, wherein said pull-down circuit comprises, for each column of said memory cells (6), two n-channel MOSFETs ($Q_6$, $Q_7$) of which the drains are connected to respective ones of said bit lines (B,$\overline{B}$), the sources are connected to earth, and the gates are connected to a pull-down signal input terminal (11) to which pull-down signals ($\phi_{PD}$) are supplied by means of a pull-down signal producing circuit (12 to 16) during chip selection.

4. A memory device according to claim 3, wherein said pull-down signal producing circuit comprises inverter circuits (13a to 13d, 15) and a NAND circuit (14).

5. A memory device according to claim 4, wherein said pull-down signal producing circuit comprises a chip-selecting signal input terminal (12) to which said chip-selecting signal ($\overline{CS}$) is supplied, one input terminal of the NAND circuit (14) being connected to said chip-selecting signal input terminal (12) by means of first, second, third and fourth inverter circuits (13a to 13d) in series, and the other input terminal of said NAND circuit (14) being connected to the output of said first inverter circuit (13a), and a pull-down signal output terminal (16) connected to the output of said NAND circuit (14).

6. A memory device according to claim 4 or claim 5, wherein said inverter circuits (13a to 13d) constitute a time-delay circuit.

7. A memory device according to any one of the preceding claims, including a bit line equalising circuit ($Q_3$).

8. A memory device according to claim 7, wherein said bit line equalising circuit includes a bit line equalising transistor comprising a p-channel MOSFET ($Q_3$).

9. A memory device according to any one of the preceding claims, including a data-line load circuit for producing data signals at an output terminal (5).

10. A memory device according to any one of the preceding claims, wherein each of said memory cells (6) comprises a flip-flop having a MOSFET.

11. A memory device according to any one of the preceding claims wherein said column-selecting transistors comprise n-channel MOSFETs

($Q_4$, $Q_5$).

12. A memory device according to any one of the preceding claims, including means (8,9) responsive to address signals (AD) for selecting one of said memory cells (6) in which data is stored and from which data is output.

**Patentansprüche**

1. Statische Speicheranordnung für wahlfreien Zugriff mit:
mehreren in Reihen und Spalten angeordneten Speicherzellen (6) zum Speichern von Daten,
Paaren von Spaltenauswahltransistoren ($Q_4$, $Q_5$) zum Auswählen jeweils einer Spalte der Speicherzellen (6),
Paaren komplementärer Bitleitungen (B, $\overline{B}$) mit welchen die mehreren Speicherzellen (6) und die Paare Spaltenauswahltransistoren ($Q_4$, $Q_5$) verbunden sind,
Paaren statischer Lasten ($Q_1$, $Q_2$), von denen jede zwischen einem der Paare komplementärer Bitleitungen (B, $\overline{B}$) und einem Energiezufuhranschluß ($V_{CC}$) geschaltet ist und
einem auf ein Chipauswahlsignal ($\overline{CS}$) ansprechenden Reihendecodierer (9) zum Auswählen einer der Reihen der Speicherzellen (6),
**gekennzeichnet durch** eine mit den Paaren Bitleitungen (B, $\overline{B}$) verbundene Spannungssteuerschaltung ($Q_6$, $Q_7$) zum Einstellen des elektrischen Potentials der Bitleitungen (B, $\overline{B}$) für eine vorbestimmte Periode in Abhängigkeit von dem Chipauswahlsignal ($\overline{CS}$), so daß eines der Paare Spaltenauswahltransistoren ($Q_4$, $Q_5$) während einer Chipauswahl zum Schreiben oder Lesen einschaltbar ist.

2. Speicheranordnung nach Anspruch 1, wobei die Spannungssteuerschaltung eine Herabsetzschaltung ($Q_6$, $Q_7$) ist.

3. Speicheranordnung nach Anspruch 2, wobei die Herabsetzschaltung für jede Spalte der Speicherzellen (6) zwei n-Kanal-MOSFETs ($Q_6$, $Q_7$) aufweist, von denen die Drains mit zugeordneten der Bitleitungen (B, $\overline{B}$), die Quellen mit Erde und die Gates mit einem Herabsetzsignal-Eingangsanschluß (11) verbunden sind, an welchen Herabsetzsignale ($\phi_{PD}$) während der Chipauswahl mittels einer Herabsetzsignal-Erzeugungsschaltung (12 bis 16) anlegbar sind.

4. Speicheranordnung nach Anspruch 3, wobei die Herabsetzsignal-Erzeugungsschaltung Inverterschaltungen (13a bis 13d, 15) und eine NAND-Schaltung (14) aufweist.

5. Speicheranordnung nach Anspruch 4, wobei die Herabsetzsignal-Erzeugungsschaltung einen Chipauswahlsignal-Eingangsanschluß (12), dem das Chipauswahlsignal ($\overline{CS}$) zugeführt ist, aufweist, wobei ein Eingangsanschluß der NAND-Schaltung (14) mit dem Chipauswahlsignal-Eingangsanschluß (12) mittels einer ersten, zweiten, dritten und vierten Inverterschaltung (13a bis 13d) in Reihe geschaltet ist und der andere Eingangsanschluß der NAND-Schaltung (14) mit dem Ausgang der ersten Inverterschaltung (13a) verbunden ist und wobei ein Herabsetzsignal-Ausgangsanschluß (16) mit dem Ausgang der NAND-Schaltung (14) verbunden ist.

6. Speicheranordnung nach Anspruch 4 oder 5, wobei die Inverterschaltungen (13a bis 13d) eine Zeitverzögerungsschaltung bilden.

7. Speicheranordnung nach einem der vorhergehenden Ansprüche mit einer Bitleitungsausgleichsschaltung ($Q_3$).

8. Speicheranordnung nach Anspruch 7, wobei die Bitleitungsausgleichsschaltung einen Bitleitungsausgleichstransistor mit einem p-Kanal-MOSFET ($Q_3$) aufweist.

9. Speicheranordnung nach einem der vorhergehenden Ansprüche, mit einer Datenleitungsladeschaltung zum Erzeugen von Datensignalen an einem Ausgangsanschluß (5).

10. Speicheranordnung nach einem der vorhergehenden Ansprüche, wobei jede der Speicherzellen (6) ein Flipflop mit einem MOSFET aufweist.

11. Speicheranordnung nach einem der vorhergehenden Ansprüche, wobei die Spaltenauswahltransistoren n-Kanal-MOSFETs (Q4, Q5) aufweisen.

12. Speicheranordnung nach einem der vorhergehenden Ansprüche, mit einer auf Adressensignale (AD) ansprechenden Einrichtung (8, 9) zum Auswählen einer der Speicherzellen (6) in welcher Daten gespeichert sind und von welcher Daten ausgegeben werden.

**Revendications**

1. Dispositif de mémoire à accès sélectif statique comprenant:
   une pluralité de cellules de mémoire (6) disposées en lignes et en colonnes, pour mémoriser des données;
   des paires de transistors de sélection de colonne ($Q_4$,$Q_5$) pour sélectionner une colonne respective desdites cellules de mémoire (6);
   des paires de fils de bit complémentaires (B,$\overline{B}$) auxquelles sont connectées ladite pluralité des cellules de mémoire (6) et lesdites paires de transistors de sélection de colonne ($Q_4$,$Q_5$);
   des paires de charges statiques ($Q_1$,$Q_2$) couplées chacune entre une paire respective desdites paires de fils de bit complémentaires (B,$\overline{B}$) et une borne de tension d'alimentation ($V_{CC}$); et
   un décodeur de ligne (9) réagissant à un signal de sélection de puce ($\overline{CS}$) pour sélectionner une desdites lignes desdites cellules de mémoire (6);
   caractérisé par un circuit de contrôle de tension ($Q_6$,$Q_7$) connecté auxdites paires de fils de bit (B,$\overline{B}$) pour régler le potentiel électrique desdits fils de bit (B,$\overline{B}$) pendant une période prédéterminée en réponse audit signal de sélection de puce ($\overline{CS}$) de manière à permettre à une desdites paires de transistors de sélection de colonne ($Q_4$,$Q_5$) d'être rendue conductrice pendant une sélection de puce pour une écriture ou une lecture.

2. Dispositif de mémoire selon la revendication 1, dans lequel ledit circuit de contrôle de tension est un circuit de baisse de tension ($Q_6$,$Q_7$).

3. Dispositif de mémoire selon la revendication 2, dans lequel ledit circuit de baisse de tension comprend, pour chaque colonne desdites cellules de mémoire (6), deux transistors à effet de champ à métal-oxyde-semiconducteur MOSFET à canal n ($Q_6$,$Q_7$) dont les drains sont connectés à des fils respectifs desdits fils de bit (B,$\overline{B}$), les sources sont connectées à la masse, et les grilles sont connectées à une borne d'entrée de signaux de baisse de tension (11) à laquelle sont fournis des signaux de baisse de tension ($\phi_{PD}$) au moyen d'un circuit producteur de signaux de baisse de tension (12 à 16) pendant une sélection de puce.

4. Dispositif de mémoire selon la revendication 3, dans lequel ledit circuit producteur de signaux de baisse de tension comprend des circuits inverseurs (13a à 13d, 15) et un circuit NON-ET (14).

5. Dispositif de mémoire selon la revendication 4, dans lequel ledit circuit producteur de signaux de baisse de tension comprend une borne d'entrée de signaux de sélection de puce (12) à laquelle est fourni ledit signal de sélection de puce ($\overline{CS}$), une borne d'entrée du circuit NON-ET (14) étant connectée à ladite borne d'entrée de signaux de sélection de puce (12) au moyen de premier, deuxième, troisième et quatrième circuits inverseurs (13a à 13d) en série, et l'autre borne d'entrée dudit circuit NON-ET (14) étant connectée à la sortie dudit premier circuit inverseur (13a), et une borne de sortie de signaux de baisse de tension (16) étant connectée à la sortie dudit circuit NON-ET (14).

6. Dispositif de mémoire selon l'une quelconque des revendications 4 et 5, dans lequel lesdits circuits inverseurs (13a à 13d) constituent un circuit à retard.

7. Dispositif de mémoire selon l'une quelconque des revendications 1 à 6, incluant un circuit égaliseur de fils de bit ($Q_3$).

8. Dispositif de mémoire selon la revendication 7, dans lequel ledit circuit égaliseur de fils de bit comprend un transistor égaliseur de fils de bit constitué par un transistor MOSFET à canal p ($Q_3$).

9. Dispositif de mémoire selon l'une quelconque des revendications 1 à 8, incluant un circuit de charge de fils de donnée pour produire des signaux de données à une borne de sortie (5).

10. Dispositif de mémoire selon l'une quelconque des revendications 1 à 9, dans lequel chacune desdites cellules de mémoire (6) comprend une bascule comportant un transistor MOSFET.

11. Dispositif de mémoire selon l'une quelconque des revendications 1 à 10, dans lequel lesdits transistors de sélection de colonne sont constitués par des transistors MOSFET à canal n ($Q_4$, $Q_5$).

12. Dispositif de mémoire selon l'une quelconque des revendications 1 à 11, incluant des moyens (8,9) réagissant à des signaux d'adresse (AD) pour sélectionner une desdites cellules de mémoire (6) dans laquelle est mémorisée une donnée et d'où est sortie une donnée.

# FIG.1

n = 16   n = 1

DECODER — 4

5

3 ADDRESS INPUT TERMINAL

# FIG.3

12  13a  13b  13c  13d  14  15  16

$\overline{CS}$   φP0

# FIG.2

# FIG.4